# EUROPEAN PATENT APPLICATION

(11) **EP 3 534 211 A1**
(43) Date of publication of application: **04.09.2019**
(21) Application number: 18159656.0
(22) Date of filing: 02.03.2018
(51) Int. Cl.: G03F 7/004, G03F 7/16, G03F 7/20

(54) **METHOD AND APPARATUS FOR FORMING A PATTERNED LAYER OF MATERIAL**

(71) Applicant: ASML Netherlands B.V., 5500 AH Veldhoven (NL)
(72) Inventor: DE JAGER, Pieter, Willem, Herman, 5500 AH Veldhoven (NL); WUISTER, Sander, Frederik, 5500 AH Veldhoven (NL); VAN LARE, Marie-Claire, 5500 AH Veldhoven (NL); MAAS, Ruben, Cornelis, 5500 AH Veldhoven (NL); POLYAKOV, Alexey, Olegovich, 5500 AH Veldhoven (NL)
(74) Representative: Peters, John Antoine

(57) **Abstract**

Methods and apparatus for forming a patterned layer of material are disclosed. In one arrangement, a selected portion of a surface of a substrate is irradiated with electromagnetic radiation having a wavelength of less than 100nm during an atomic layer deposition process. The irradiation locally drives the atomic layer deposition process in the selected region and thereby causes the atomic layer deposition process to form a layer of material in a pattern defined by the selected portion.

## Description

### FIELD

The present invention relates to methods and apparatus for forming a patterned layer of material.

### BACKGROUND

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable creation of increasingly smaller features.

Many semiconductor manufacturing processes rely on lithography. Exposure of a substrate during lithography is performed field by field, whereas most or all other steps (e.g. etching, depositing, chemical mechanical planarization (CMP), implanting) are performed for the whole substrate simultaneously. As lithography processing moves to smaller features, requirements for uniformity across the substrate increase, which means that full substrate processing is becoming more challenging. Critical dimension uniformity may be limited by chemical noise in photo-resist.

The tunnelling FET is a promising candidate for incorporation into future transistor layouts because of its short decay time and zero dark-current (and therefore low power consumption). Fabrication of tunnelling FETs is challenging because of the need to form patterned stacks of atomic monolayers, such as MoS₂. Lithography can be used to perform the patterning but it has been found that processes for etching or stripping photo-resist can introduce defects into the atomic monolayers, thereby affecting yield.

### SUMMARY

It is an object of the invention to provide alternative or improved methods and apparatus for forming patterned layers.

According to one aspect, there is provided a method of forming a patterned layer of material, comprising: irradiating a selected portion of a surface of a substrate with electromagnetic radiation having a wavelength of less than 100nm during an atomic layer deposition process, the irradiation being such as to locally drive the atomic layer deposition process in the selected region and thereby cause the atomic layer deposition process to form a layer of material in a pattern defined by the selected portion.

Thus, a method is provided in which a radiation pattern defines where an atomic layer deposition process occurs, thereby allowing a patterned layer of material to be formed without the need for a resist. Use of EUV radiation (radiation having a wavelength less than 100nm) has been found to be effective and practical, thereby allowing high resolution features to be formed using the disclosed technique. Potentially damaging processing steps associated with removing resist can be avoided. In the context of semiconductor device manufacturing, it is expected that errors associated with chemical noise can be reduced because precursor materials used in atomic layer deposition are small molecules in comparison with typical resist materials. The contribution from chemical noise to local critical dimension non-uniformity is expected to be smaller than for chemically amplified resists and non-chemically amplified resists where the building block is either a polymer or a metal oxide nanoparticle. Improving local critical dimension uniformity can contribute to improve edge placement accuracy of device features.

Irradiating the substrate during the atomic layer deposition process not only allows patterns to be defined directly but can also speed up the atomic layer deposition process relative to configurations which do not use irradiation, thereby providing good throughput.

Because the driving of the atomic layer deposition process involves chemical reactions occurring intrinsically at the surface being processed, the accuracy of resulting patterns will be relatively insensitive to variations in the stack below the surface.

A single integrated process achieves what would need several distinct processes in an alternative resist-based semiconductor manufacturing process (e.g. exposure, development, deposition, etc.). This may provide increased scope for process optimization.

In an embodiment, the driving of the atomic layer deposition process in the selected portion comprises driving a chemical reaction involving a precursor material, wherein the chemical reaction comprises a photochemical reaction driven by the irradiation, and the photochemical reaction is a multi-photon photochemical reaction involving absorption of two or more photons by each of at least one species involved in the photochemical reaction. Configuring the atomic layer deposition so that the irradiation drives multi-photon photochemical reactions allows particularly high spatial contrast to be achieved.

In an embodiment, the driving of the chemical reaction comprises generating a reactive species by the radiation locally interacting with a gas above the selected region. Using the radiation to locally generate reactive species allows spatially controlled deposition or modification of a wide range of materials.

According to an aspect, there is provided a method of forming a patterned layer of material, comprising: irradiating a selected portion of a surface of a substrate with electromagnetic radiation during an atomic layer deposition process, the irradiation being such as to locally drive the atomic layer deposition process in the selected region and thereby cause the atomic layer deposition process to form a layer of material in a pattern defined by the selected portion, wherein: the atomic layer deposition process comprises two steps and the irradiation of the selected portion is performed during at least one of the two steps and while the selected portion of the substrate is in contact with a liquid.

Thus, a method is provided in which a radiation pattern applied during an immersion process (where the selected portion is covered with liquid) can define where an atomic layer deposition process occurs, thereby allowing a patterned layer of material to be formed without the need for a resist in an expanded range of atomic layer deposition procedures (in comparison to the case where the radiation pattern is applied purely through a gaseous environment). A flow of the immersion liquid can also conveniently carry away by-products produced by the irradiation.

According to an aspect, there is provided an apparatus for forming a patterned layer of material, comprising: an irradiation system configured to irradiate a selected portion of a surface of a substrate with electromagnetic radiation having a wavelength of less than 100nm during an atomic layer deposition process; and an environment control system configured to allow the composition of the environment above the substrate to be controlled in such a way as to allow the atomic layer deposition process to proceed.

According to an aspect, there is provided an apparatus for forming a patterned layer of material, comprising: an irradiation system configured to irradiate a selected portion of a surface of a substrate with electromagnetic radiation during an atomic layer deposition process; and an environment control system configured to allow the composition of the environment above the substrate to be controlled in such a way as to allow the atomic layer deposition process to proceed, wherein the environment control system is configured to allow a liquid to be maintained in contact with the selected portion during irradiation of the selected portion in at least one step of the atomic layer deposition process.

In an embodiment, the irradiation system comprises a lithographic apparatus configured to provide the irradiation of the selected portion by projecting a patterned radiation beam from a patterning device onto the substrate.

Thus, capabilities of lithography apparatus developed to achieve high precision exposure of resist can be exploited to allow accurate formation of patterns in an atomic layer deposition process without using resist. High accuracy can be achieved using fewer processing steps and/or without losses in yield associated with having to remove resist.

### BRIEF DESCRIPTION OF THE DRAWINGS

Embodiments of the invention will now be described, by way of example only, with reference to the accompanying schematic drawings, in which:
- Figure 1 depicts a first example of a lithographic system comprising a lithographic apparatus and a radiation source;
- Figure 2 depicts a second example of a lithographic system comprising a lithographic apparatus and a radiation source;
- Figure 3 is a schematic side view of a tunnelling FET;
- Figure 4 schematically depicts irradiation of a selected region on a substrate during a first step of an atomic layer deposition process;
- Figure 5 schematically depicts a step in the atomic layer deposition process subsequent to the step depicted in Figure 4;
- Figure 6 schematically depicts a lithographic apparatus providing radiation to an environment control system according to an embodiment;
- Figure 7 schematically depicts irradiation of a selected portion of a substrate to locally drive a pyrolytic chemical reaction forming part of an atomic layer deposition process;
- Figure 8 schematically depicts a step in the atomic layer deposition process subsequent to the step depicted in Figure 7; and
- Figure 9 schematically depicts irradiation of a selected portion of a substrate to locally generate a reactive species participating in an atomic layer deposition process.

### DETAILED DESCRIPTION

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus which uses extreme ultraviolet (EUV) radiation, having a wavelength of less than 100nm, optionally in the range of 5-100 nm, optionally within a range of 4 nm to 20 nm, for example 6.7 nm or 13.5 nm, may be used to form smaller features on a substrate than a lithographic apparatus which uses, for example, radiation with a wavelength of 193 nm.

In the present document, the terms "radiation" and "beam" are used to encompass all types of electromagnetic radiation unless stated otherwise, including ultraviolet radiation (e.g. with a wavelength of 365, 248, 193, 157 or 126 nm) and EUV (extreme ultra-violet radiation, e.g. having a wavelength in the range of about 5-100 nm).

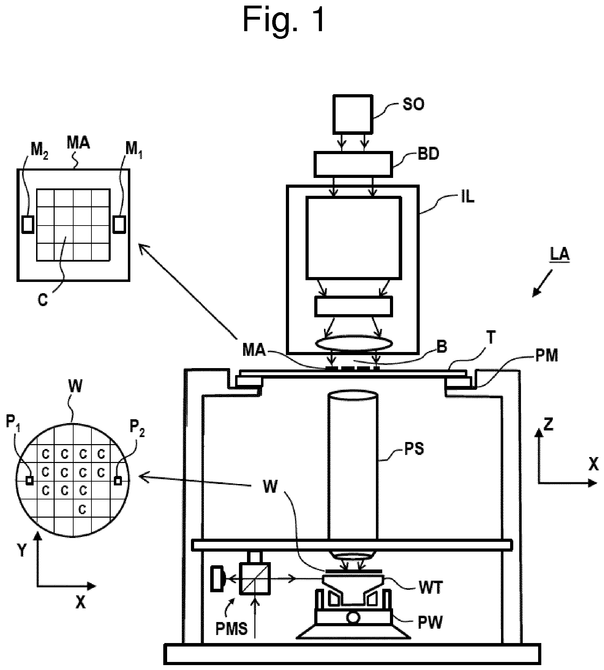

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

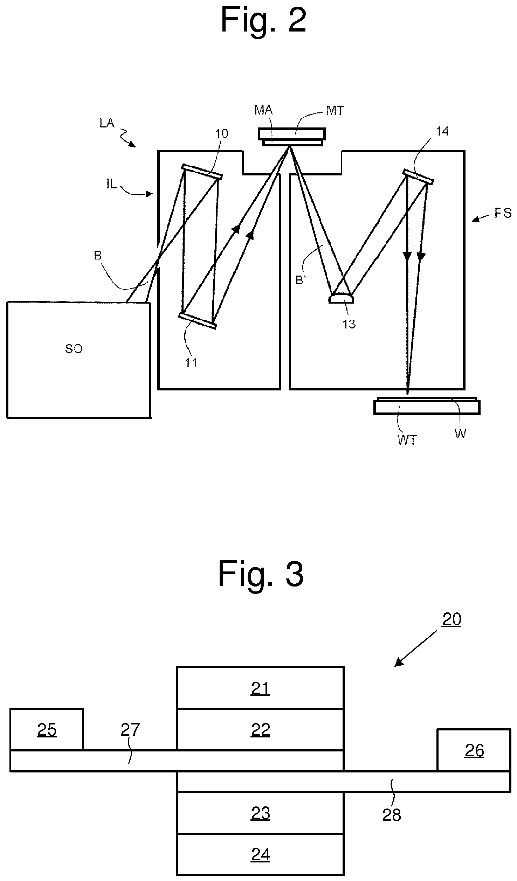

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

Figure 3 is a schematic side view of a tunnelling FET 20. The tunnelling FET 20 comprises a vertical stack of layers comprising a top gate 21, an upper dielectric layer 22, a lower dielectric layer 23 and a bottom gate 24. A source 25 and a drain 26 are respectively connected to the vertical stack of layers by two-dimensional layers 27 and 28. Each of the two-dimensional layers 27 and 28 may consist of a layer that is one atomic thick, which may also be referred to as a monolayer or single atomic layer. Either or both of the two-dimensional layers 27 and 28 may be formed from MoS₂ or hexagonal-BN for example. Manufacture of the tunnelling FET 20 requires patterning of the two-dimensional layers 27 and 28 in the lateral direction. As mentioned in the introductory part of the description, the patterning can be performed using lithography applied to a photo-resist, but this approach can introduce defects. Embodiments of the present disclosure provide an alternative approach for forming a patterned layer of material. Embodiments can be used for manufacturing at least one monolayer (e.g. one or both of the two-dimensional layers 27 and 28) of a tunnelling FET or for manufacturing other semiconductor devices or for manufacturing devices which are not semiconductor devices.

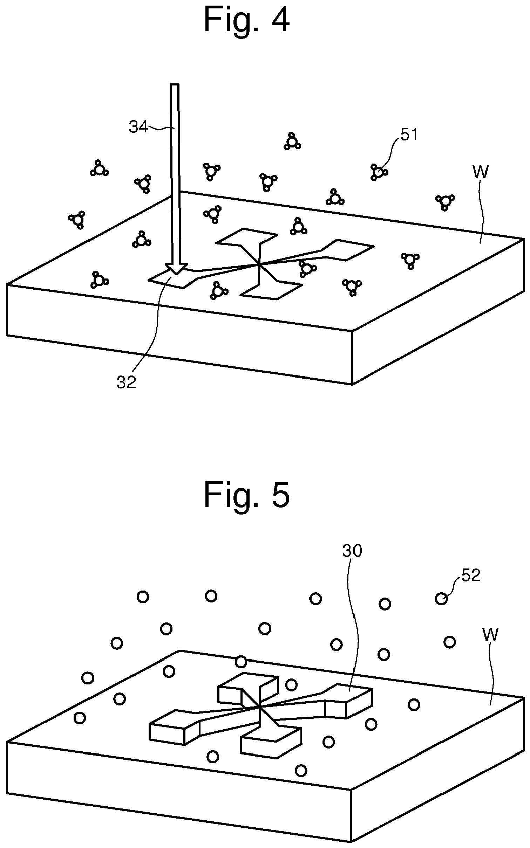

Figures 4 and 5 schematically depict formation of a patterned layer of material 30 according to a method of an embodiment. As depicted in Figure 4, the method comprises irradiating 34 a selected portion 32 of a surface of a substrate W during an atomic layer deposition process. The irradiation locally drives the atomic layer deposition process in the selected region 32 and thereby causes the atomic layer deposition process to form a layer of material 30 (see Figure 5) in a pattern defined by the selected portion 32. A pattern is thus formed without needing any resist. No processing to remove a resist is therefore required, which reduces the risk of damage to the patterned layer of material 30. In contrast to traditional lithography-based semiconductor manufacturing processes, instead of being used to break or cross-link molecules in a resist, radiation is being used to drive a chemical reaction involved in an atomic layer deposition process.

In this embodiment, the irradiation is performed with radiation comprising, consisting essentially of, or consisting of any type of EUV radiation (having a wavelength less than 100nm) that is capable of locally driving the atomic layer deposition process. The use of EUV radiation provides high spatial resolution. In some other embodiments, the irradiation is performed with radiation comprising, consisting essentially of, or consisting of, higher wavelength radiation in combination with an immersion liquid, as described below. The higher wavelength radiation may be in the range of 100nm to 400nm (including DUV radiation).

Atomic layer deposition is a known thin-film deposition technique in which each of at least two chemicals (which may be referred to as precursor materials) are made to react with the surface of a material in a sequential, self-limiting, manner. In contrast to chemical vapor deposition, the two precursor materials are never present simultaneously above the substrate W.

In embodiments of the present disclosure, the atomic layer deposition comprises at least a first step and a second step. In the first step, an example of which is depicted in Figure 4, a first precursor material 51 is made to react with a surface of a substrate W. In the second step, an example of which is depicted in Figure 5, a second precursor material 52 is made to react with the substrate W in a region where the first precursor 51 reacted with the substrate W in the first step (in this example the selected regions 32).

In the example of Figures 4 and 5, the substrate W is irradiated in the first step only. In other embodiments, the irradiation of the selected portion 32 is performed during the second step only or during the first step and the second step. In embodiments not involving immersion liquid, the irradiation of the selected portion 32 in at least one of the two steps is performed using EUV radiation. Irradiation may additionally be performed in one or more other steps using other forms of irradiation (with or without an immersion liquid), including DUV radiation.

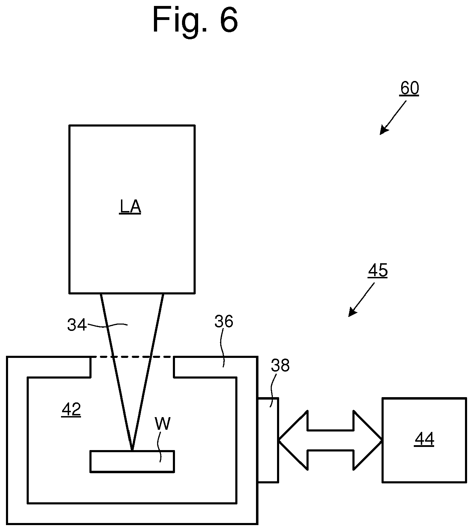

Figure 6 schematically depicts an apparatus 60 for performing the method. The apparatus 60 thus forms a patterned layer of material. The apparatus 60 comprises an irradiation system. The irradiation system may comprise a lithographic apparatus LA. The lithographic apparatus LA irradiates the selected portion 32 by projecting a patterned radiation beam from a patterning device MA onto the substrate W. The lithographic apparatus LA may be configured as described above with reference to Figure 1 (e.g. when the irradiation comprises DUV radiation and/or immersion lithography is required) or as described above with reference to Figure 2 (e.g. when the irradiation comprises EUV radiation).

In an embodiment, the lithographic apparatus LA is configured to perform immersion lithography. In such an embodiment, the atomic layer deposition process may comprise a step in which the selected portion 32 is irradiated while the selected portion 32 is in contact with an immersion liquid. Thus, for example, the atomic layer deposition process may comprise a first step comprising adsorption of a precursor from a gaseous precursor material to the substrate W and a second step in which the adsorbed precursor is modified in the selected portion 32 (e.g. to remove a by-product of the adsorption process) by irradiation through the immersion liquid. Any by-product produced by the irradiation through the immersion liquid can conveniently be carried away by flow of the immersion liquid. In an embodiment, the irradiated substrate W is subsequently dried and any further required processing is performed on the dried substrate W.

In an embodiment, an environment control system 45 is provided. The environment control system 45 allows the composition of the environment 42 above the substrate W to be controlled in such a way as to allow the atomic layer deposition process to proceed. In an embodiment, the environment control system 45 comprises a chamber 36 to provide a sealed environment 42 including the selected portion 32 of the surface of the substrate W. In some embodiments, all of the substrate W will be within the chamber 36 during the atomic deposition process. In an embodiment, a materials exchange system 38 (e.g. a port into the chamber 36 and associated valves and/or conduits) is provided that allows materials to be added to and removed from the sealed environment 42 to allow different compositional environments to be established within the sealed environment 42. Materials may be provided to and from the materials exchange system 38 by a flow manager 44. The flow manager 44 may comprise any suitable combination of reservoirs, ducting, valves, sinks, pumps, control systems, and/or other components necessary to provide the required flows of materials into and out of the chamber 36. The different compositional environments achieved in this way correspond to different respective stages of the atomic layer deposition process. In some embodiments, the materials added to and removed from the chamber 36 are gaseous, thereby providing compositional environments consisting of different combinations of gases. In an embodiment in which one or more steps of the atomic layer deposition process are perform by irradiating the substrate W through an immersion liquid, the environment control system 45 may be configured to allow switching between a state in which a controlled liquid environment is maintained above the substrate W (e.g. during exposure in an immersion lithography mode) and a state in which a controlled gaseous environment is maintained above the substrate W (e.g. during adsorption of a precursor from a gaseous precursor material).

In some embodiments, the driving of the atomic layer deposition process in the selected portion 32 comprises driving a chemical reaction involving a precursor material. The precursor material will be provided as part of the compositional environment established above the substrate during the irradiation. The driving of the chemical reaction may cause the chemical reaction to proceed at a faster rate than would be the case in the absence of the irradiation. Alternatively, the chemical reaction may be such that it would not occur at all in the absence of the irradiation. In an embodiment, the chemical reaction is endothermic and the irradiation provides the energy necessary to allow the chemical reaction to proceed. In some embodiments, the chemical reaction is at least partially driven by heat generated in the substrate W by the irradiation. Thus, the chemical reaction being driven by the irradiation may comprise a chemical reaction that requires an elevated temperature to proceed or which proceeds more rapidly at elevated temperatures. In some embodiments, the chemical reaction comprises a photochemical reaction driven by the irradiation. Thus, at least one species involved in the chemical reaction directly absorbs a photon from the irradiation and the absorption of the photon allows the chemical reaction to proceed. In some embodiments, the photochemical reaction comprises a multi-photon photochemical reaction involving absorption of two or more photons by each of at least one species involved in the photochemical reaction. The requirement for two or more photons to be absorbed makes the chemical reaction much more sensitive to variations in the intensity of the irradiation (i.e. the rate of the chemical reaction varies much more strongly as a function of intensity) than would be the case for single photon photochemical reactions. The increased sensitivity to intensity provides improved lateral contrast. In an embodiment, a combination of a photochemical reaction and radiation induced heating is used to provide a well defined process window in which the chemical reaction is driven locally to produce the pattern.

In an embodiment, the irradiation drives an endothermic chemical reaction in a precursor material comprising, consisting essentially of, or consisting of, Mo(thd)₃, where thd = 2,2,6,6-tetramethylheptane-3,5-dionato. The irradiation causes deposition of Mo in the selected region 32. Mo is not deposited outside of the selected region 32. This chemical reaction is an example of a two-photon photochemical reaction. A high contrast patterned layer of Mo can therefore be achieved. Subsequent steps of the atomic layer deposition process can be performed as desired to build up the material of interest in a shape defined by the irradiation (i.e. above the selected region 32 and not elsewhere). A further material may be grown on the layer of Mo for example. In an embodiment, the further material comprises S. A patterned monolayer of MoS₂ can therefore be formed. The patterned monolayer of MoS₂ may be used in a tunnelling FET, for example, as described above.

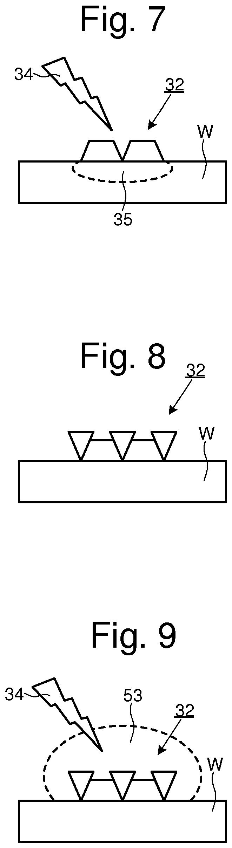

In an embodiment, the chemical reaction comprises a pyrolytic process involving dissociation of the precursor material adsorbed to the selected region 32. Steps in an embodiment of this type are schematically depicted in Figures 7 and 8. This embodiment is an example of a situation where the chemical reaction is at least partially driven by heat 35 generated in the substrate W by the irradiation 34. As depicted in Figure 7, the heat 35 causes dissociation of molecules of the precursor material exclusively in the selected region 32 during a first step of an atomic layer deposition process. A patterned layer of material is thus provided. Figure 8 shows a subsequent step of the atomic layer deposition process in which material in the selected region 32 (and no other region) is modified. The subsequent step may comprise oxidation or reduction, for example, of the patterned layer of material formed in the first step.

In an embodiment, the driving of the chemical reaction comprises generating a reactive species 53 by the radiation locally interacting with a gas above the selected region 32. An example of such an interaction is depicted schematically in Figure 9. In an embodiment, the generated reactive species 53 comprises an oxidizing agent or a reducing agent. The generated reactive species may comprise ozone formed from O₂, using DUV irradiation for example. Alternatively, the generated reactive species 53 may comprise dissociated H₂O formed for example by irradiating water vapor with UV radiation. Alternatively, the generated reactive species 53 may comprise dissociated NH₃. Atomic layer deposition chemical reactions which only occur when the reactive species is present can thus be driven to occur only in the selected region 32 defined by the irradiation. Although these processes may use DUV radiation, if other steps in the method use EUV radiation, even higher spatial resolution than is possible using DUV only may be achieved.

In an embodiment, the atomic layer deposition process comprises one or more of the following reactions:
BBr₃+NH₃ to create BN
Zn(OC₂H₅)₂+H₂O to create ZnO
Ta(OC₂H₅)₂+H₂O to create Ta₂O₅
Ta(OC₂H₅)₅+O₂ to create Ta₂O₅
Al(CH₃)₃+O₂ to create Al₂O₃
Ti(OCH(CH₃)₂)₄+O₂ to create TiO₂

In each of the above six example reactions, the first component comprises a precursor material in gaseous form and the second component comprises an oxidizer. All of these reactions are photoactive.

For the NH₃ based reaction, the atomic layer deposition process may comprise a step of irradiating the NH₃, for example using an excimer laser, to dissociate the NH₃ (the same excimer laser may also be used in this case to dissociate the precursor material BBr₃). A patterned monolayer of hexagonal-BN can therefore be formed. The patterned monolayer of hexagonal-BN may be used in a tunnelling FET, for example, as described above.

For the H₂O based reactions, the atomic layer deposition process may comprise a step of irradiating water vapor using UV radiation to dissociate the water vapor. For the O₂ based reactions, the atomic layer deposition process may comprise a step of irradiating O₂ with DUV radiation to produce ozone.

The embodiments may further be described using the following clauses:
1. A method of forming a patterned layer of material, comprising:
   irradiating a selected portion of a surface of a substrate with electromagnetic radiation having a wavelength of less than 100nm during an atomic layer deposition process, the irradiation being such as to locally drive the atomic layer deposition process in the selected region and thereby cause the atomic layer deposition process to form a layer of material in a pattern defined by the selected portion.
2. The method of clause 1, wherein the driving of the atomic layer deposition process in the selected portion comprises driving a chemical reaction involving a precursor material.
3. The method of clause 2, wherein the chemical reaction comprises a photochemical reaction driven by the irradiation.
4. The method of clause 3, wherein the photochemical reaction is a multi-photon photochemical reaction involving absorption of two or more photons by each of at least one species involved in the photochemical reaction.
5. The method of clause 4, wherein the multi-photon photochemical reaction is a two-photon photochemical reaction.
6. The method of any of clauses 2 to 5, wherein the precursor material comprises Mo(thd)₃, where thd = 2,2,6,6-tetramethylheptane-3,5-dionato.
7. The method of any of clauses 2 to 6, wherein the chemical reaction is at least partially driven by heat generated in the substrate by the irradiation.
8. The method of clause 7, wherein the chemical reaction comprises a pyrolytic process involving dissociation of the precursor material adsorbed to the selected region.
9. The method of any of clauses 2 to 8, wherein the precursor material comprises one or more of the following: BBr₃, Zn(OC₂H₅)₂, Ta(OC₂H₅)₂, Ta(OC₂H₅)₅, Al(CH₃)₃, Ti(OCH(CH₃)₂)₄.
10. The method of any of clauses 2 to 9, wherein the driving of the chemical reaction comprises generating a reactive species by the radiation locally interacting with a gas above the selected region.
11. The method of clause 10, wherein the generated reactive species comprises an oxidising agent or a reducing agent.
12. The method of clause 10 or 11, wherein the generated reactive species comprises one or more of the following: dissociated O₂, dissociated H₂O, dissociated NH₃.
13. The method of any preceding clause, wherein the atomic layer deposition process comprises two steps and the irradiation of the selected portion of the surface of the substrate is performed during either or both of the two steps.
14. The method of clause 13, wherein at least one of the steps comprises irradiating the selected portion of the substrate while the selected portion of the substrate is in contact with a liquid.
15. The method of any of clauses 1 to 13, wherein the electromagnetic radiation has a wavelength in the range of 4nm to 20nm.
16. A method of forming a patterned layer of material, comprising:
   irradiating a selected portion of a surface of a substrate with electromagnetic radiation during an atomic layer deposition process, the irradiation being such as to locally drive the atomic layer deposition process in the selected region and thereby cause the atomic layer deposition process to form a layer of material in a pattern defined by the selected portion, wherein:
      the atomic layer deposition process comprises two steps and the irradiation of the selected portion is performed during at least one of the two steps and while the selected portion of the substrate is in contact with a liquid.
17. A method of forming a semiconductor device, comprising using the method of any of clauses 1 to 16 to form at least one layer in the device.
18. The method of clause 17, wherein the semiconductor device comprises a tunnelling FET and the method of any of clauses 1 to 16 is used to form at least one monolayer of the tunnelling FET.
19. An apparatus for forming a patterned layer of material, comprising:
   an irradiation system configured to irradiate a selected portion of a surface of a substrate with electromagnetic radiation having a wavelength of less than 100nm during an atomic layer deposition process; and
   an environment control system configured to allow the composition of the environment above the substrate to be controlled in such a way as to allow the atomic layer deposition process to proceed.
20. An apparatus for forming a patterned layer of material, comprising:
   an irradiation system configured to irradiate a selected portion of a surface of a substrate with electromagnetic radiation during an atomic layer deposition process; and
   an environment control system configured to allow the composition of the environment above the substrate to be controlled in such a way as to allow the atomic layer deposition process to proceed,
   wherein the environment control system is configured to allow a liquid to be maintained in contact with the selected portion during irradiation of the selected portion in at least one step of the atomic layer deposition process.
21. The apparatus of clause 19 or 20, wherein the environment control system comprises:
   a chamber to provide a sealed environment including the selected portion of the surface of the substrate; and
   a materials exchange system configured to allow materials to be added to and removed from the sealed environment to allow different compositional environments to be established within the sealed environment, the different compositional environments corresponding to different respective steps of the atomic layer deposition process.
22. The apparatus of any of clauses 19 to 21, wherein the irradiation system comprises a lithographic apparatus configured to provide the irradiation of the selected portion by projecting a patterned radiation beam from a patterning device onto the substrate.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method of forming a patterned layer of material, comprising:
irradiating a selected portion of a surface of a substrate with electromagnetic radiation having a wavelength of less than 100nm during an atomic layer deposition process, the irradiation being such as to locally drive the atomic layer deposition process in the selected region and thereby cause the atomic layer deposition process to form a layer of material in a pattern defined by the selected portion.

2. The method of claim 1, wherein the driving of the atomic layer deposition process in the selected portion comprises driving a chemical reaction involving a precursor material.

3. The method of claim 2, wherein the chemical reaction comprises a photochemical reaction driven by the irradiation.

4. The method of claim 3, wherein the photochemical reaction is a multi-photon photochemical reaction involving absorption of two or more photons by each of at least one species involved in the photochemical reaction.

5. The method of claim 4, wherein the multi-photon photochemical reaction is a two-photon photochemical reaction.

6. The method of claim 2, wherein the precursor material comprises Mo(thd)₃, where thd = 2,2,6,6-tetramethylheptane-3,5-dionato.

7. The method of claim 2, wherein the chemical reaction is at least partially driven by heat generated in the substrate by the irradiation.

8. The method of claim 7, wherein the chemical reaction comprises a pyrolytic process involving dissociation of the precursor material adsorbed to the selected region.

9. The method of claim 2, wherein the precursor material comprises one or more of the following: BBr₃, Zn(OC₂H₅)₂, Ta(OC₂H₅)₂, Ta(OC₂H₅)₅, Al(CH₃)₃, Ti(OCH(CH₃)₂)₄.

10. The method of claim 2, wherein the driving of the chemical reaction comprises generating a reactive species by the radiation locally interacting with a gas above the selected region.

11. The method of claim 10, wherein the generated reactive species comprises an oxidising agent or a reducing agent.

12. The method of claim 1, wherein the atomic layer deposition process comprises two steps and the irradiation of the selected portion of the surface of the substrate is performed during either or both of the two steps.

13. The method of claim 12, wherein at least one of the steps comprises irradiating the selected portion of the substrate while the selected portion of the substrate is in contact with a liquid.

14. The method of claim 1, wherein the electromagnetic radiation has a wavelength in the range of 4nm to 20nm.

15. An apparatus for forming a patterned layer of material, comprising:
an irradiation system configured to irradiate a selected portion of a surface of a substrate with electromagnetic radiation having a wavelength of less than 100nm during an atomic layer deposition process; and
an environment control system configured to allow the composition of the environment above the substrate to be controlled in such a way as to allow the atomic layer deposition process to proceed.
